# EUROPEAN PATENT APPLICATION

(11) **EP 4 597 478 A1**
(43) Date of publication of application: **06.08.2025**
(21) Application number: 23907344.8
(22) Date of filing: 17.10.2023
(51) Int. Cl.: G09F 9/302, F16H 25/20, F16H 25/24, H01L 25/075, H01L 27/15

(54) **DISPLAY DEVICE**

(30) Priority: 22.12.2022 KR 20220182350
(71) Applicant: Samsung Electronics Co., Ltd., Suwon-si, Gyeonggi-do 16677 (KR)
(72) Inventor: LEE, Yongjune, Suwon-si Gyeonggi-do 16677 (KR); PARK, Jaehoo, Suwon-si Gyeonggi-do 16677 (KR); IM, Sangkyun, Suwon-si Gyeonggi-do 16677 (KR); JUNG, Kilsoo, Suwon-si Gyeonggi-do 16677 (KR)
(74) Representative: Appleyard Lees IP LLP
(86) International application number: PCT/KR2023/016027
(87) International publication number: WO 2024/136058

(57) **Abstract**

This display device comprises: a first display panel and a second display panel, which can be positioned to at least partially overlap the first display panel, each of the first display panel and the second display panel including a light-emitting area and a transmission area through which light can be transmitted; a first driving device which moves the first display panel and/or the second display panel so that the first display panel can overlap at least a part of the second display panel, and which includes a first motor; and a second driving device which moves the first display panel and/or the second display panel in the forward-backward direction so as to adjust the distance between the first display panel and the second display panel, and which includes a second motor.

## Description

### [TECHNICAL FIELD]

The present disclosure relates to a display apparatus, and more particularly, to a display apparatus configured to move a display panel.

### [BACKGROUND ART]

In general, a display apparatus is a device for displaying images, and recently transparent displays and three-dimensional image displays are being developed.

The transparent display apparatus may be used in various fields by increasing a transmittance of a display panel to allow objects located behind the display panel to be seen.

In order to provide the three-dimensional effect to an image displayed on the transparent display, a plurality of transparent displays may be overlapped and used, but there is a characteristic that the transmittance decreases as the image passes through the display.

Therefore, it is required to move the display panel depending on the image that the transparent display wants to display, and a display apparatus suitable for a wider range of purposes may be provided through variable arrangement of the transparent display.

### [DISCLOSURE]

### [TECHNICAL PROBLEM]

The present disclosure is directed to providing a display apparatus capable of moving a display panel.

Further, the present disclosure is directed to providing a display apparatus capable of providing a three-dimensional image by overlapping a plurality of display panels.

Further, the present disclosure is directed to providing a display apparatus capable of providing a wide screen by expanding a plurality of display panels.

Further, the present disclosure is directed to providing a display apparatus capable of providing an image having the high resolution by overlapping a plurality of display panels.

Additional aspects of the disclosure will be set forth in part in the description which follows and, in part, will be obvious from the description, or may be learned by practice of the disclosure.

### [TECHNICAL SOLUTION]

One aspect of the present disclosure provides a display apparatus including: a first display panel, and a second display panel capable of being positioned to at least partially overlap the first display panel, each of the first display panel and the second display panel including a light-emitting area and a transmission area through which light is transmitted; a first driving device configured to move at least one of the first display panel or the second display panel to allow the first display panel to overlap at least a portion of the second display panel, and including a first motor; and a second driving device configured to move at least one of the first display panel or the second display panel in a front and rear direction so as to adjust a distance between the first display panel and the second display panel, the second driving device including a second motor.

The light-emitting area of the second display panel may be positioned to correspond to the transmission area of the first display panel.

Each of the first display panel and the second display panel may further include a first wiring portion in which the light-emitting area is positioned, and a second wiring portion that intersects the first wiring portion and forms the transmission area together with the first wiring portion.

The light-emitting area of the second display panel may be positioned to overlap at least a portion of the first wiring portion of the first display panel.

The first wiring portion and the second wiring portion may intersect each other vertically.

The first display panel and the second display panel may be capable of being arranged side by side to form a single continuous screen.

The first display panel and the second display panel may be capable of being arranged along the front and rear direction to allow all areas of the first display panel and the second display panel to overlap each other.

In response to the overlap of the first display panel and the second display panel, the light-emitting area of the second display panel may be capable of being positioned to correspond to the transmission area of the first display panel.

Each of the first display panel and the second display panel may include a first wiring portion in which the light-emitting area is positioned, and a second wiring portion that intersects the first wiring portion and forms the transmission area together with the first wiring portion. In response to the complete overlap of the first display panel and the second display panel, the light-emitting area of the second display panel may be capable of being positioned to overlap at least a portion of the first wiring portion of the first display panel.

The first display panel and the second display panel may have different sizes.

The second display panel may be provided to be smaller than the first display panel.

The display apparatus may further include a third display panel positioned to overlap at least a portion of the first display panel or the second display panel. The third display panel may be capable of being arranged side by side with the first display panel and the second display panel to form a single continuous screen.

The first driving device may include a motor gear configured to be rotated by the first motor. The first driving device may include a first gear configured to be rotated by the rotation of the motor gear.

The first driving device may include a first screw configured to be rotated together with the first gear.

The first driving device may include a first transfer unit configured to be movable along the first screw.

The first driving device may include a second gear configured to be rotated by the rotation of the motor gear. The first driving device may include a second screw configured to be rotated together with the second gear and positioned parallel to the first screw. The first driving device may further include a second transfer unit configured to be movable along the second screw. The second screw may have a thread in a different direction from the first screw.

The second driving device may further include a moving block mounted on the second display panel and movably coupled to the second transfer unit. The second driving device may move the moving block in the front and rear direction by the rotation of the second motor.

The display apparatus may further include a controller configured to control the first driving device or the second driving device based on a user input. The controller may control the first driving device or the second driving device to allow the display apparatus to be operated in a first mode for expanding an image display region and a second mode for increasing the resolution.

Another aspect of the present disclosure provides a display apparatus including: a first display panel and a second display panel positioned to at least partially overlap the first display panel, each of the first display panel and the second display panel including a light-emitting area and a transmission area through which light is transmitted; a first driving device configured to move at least one of the first display panel or the second display panel to allow the first display panel to overlap at least a portion of the second display panel, and a second driving device configured to move at least one of the first display panel or the second display panel in a front and rear direction so as to adjust a distance between the first display panel and the second display panel; and a controller configured to control the first driving device or the second driving device based on a user input.

The controller may control the first driving device or the second driving device to allow the display apparatus to be operated in a first mode for expanding an image display region. The controller may control the first driving device or the second driving device to allow the display apparatus to be operated in a second mode for increasing the resolution.

In response to the display apparatus being operated in the first mode, the controller may control the first driving device or the second driving device to allow the first display panel and the second display panel to be arranged side by side to form a single continuous screen.

In response to the display apparatus being operated in the second mode, the controller may control the first driving device or the second driving device to allow the light-emitting area of the second display panel to be positioned to correspond to the transmission area of the first display panel.

Another aspect of the present disclosure provides a display apparatus including: a first display panel and a second display panel, each of the first display panel and the second display panel including a first wiring portion in which a light-emitting area is positioned, and a second wiring portion that intersects the first wiring portion and forms a transmission area together with the first wiring portion; a first driving device configured to move at least one of the first display panel or the second display panel to allow the first display panel to overlap at least a portion of the second display panel, and a second driving device configured to move at least one of the first display panel or the second display panel in a front and rear direction so as to adjust a distance between the first display panel and the second display panel; and a controller configured to control the first driving device or the second driving device based on a user input. The controller may control the first driving device or the second driving device to allow the display apparatus to be operated in a first mode for expanding an image display region. The controller may control the first driving device or the second driving device to allow the display apparatus to be operated in a second mode for increasing the resolution. The controller may control the first driving device or the second driving device to allow the display apparatus to be operated in a third mode for increasing a transmittance in the second mode.

In response to the display apparatus being operated in the first mode, the controller may control the first driving device or the second driving device to allow the first display panel and the second display panel to be arranged side by side to form a single continuous screen. In response to the display apparatus being operated in the second mode, the controller may control the first driving device or the second driving device to allow the light-emitting area of the second display panel to be positioned to correspond to the transmission area of the first display panel. In response to the display apparatus being operated in the third mode, the controller may control the first driving device or the second driving device to allow at least a portion of the light-emitting area of the second display panel to be positioned to correspond to the first wiring portion of the first display panel.

### [ADVANTAGEOUS EFFECTS]

It is possible to move a display panel.

Further, it is possible to provide a three-dimensional effect to an image by overlapping display panels.

Further, it is possible to provide an image on a wide screen.

Further, it is possible to increase the resolution by overlapping display panels.

Additional aspects of the disclosure will be set forth in part in the description which follows and, in part, will be obvious from the description, or may be learned by practice of the disclosure.

### [DESCRIPTION OF DRAWINGS]

FIG. 1 is a view illustrating a display apparatus according to one embodiment.
FIG. 2 is a control block diagram of the display apparatus according to one embodiment.
FIG. 3 is a view illustrating a state in which display panels of the display apparatus of FIG. 1 are expanded and arranged.
FIG. 4 is a view illustrating a light-emitting area and a transmission area forming the display panel of FIG. 3.
FIG. 5 is an enlarged view of a portion A, which is a portion of the light-emitting area and the transmission area of the display panel of FIG. 3.
FIG. 6 is a view illustrating a state in which the display panels of the display apparatus of FIG. 1 are overlapped and arranged.
FIG. 7 is a view illustrating the light-emitting area and the transmission area forming the display panel of FIG. 6.
FIG. 8 is a view illustrating a structure of a light-emitting area and a transmission area forming a display panel of a display apparatus according to one embodiment.
FIG. 9 is a view illustrating a state in which the display panels of the display apparatus of FIG. 8 are overlapped and arranged.
FIG. 10 is a view illustrating a state in which the display panels of the display apparatus of FIG. 8 are arranged in a manner different from that of FIG. 8.
FIG. 11 is a view illustrating a state in which a portion of the display panels of the display apparatus of FIG. 1 are overlapped and arranged.
FIG. 12 is a view illustrating a state in which a first display panel is provided to be smaller than a second display panel according to one embodiment.
FIG. 13 is a view illustrating a state in which a first display panel is provided to be larger than a second display panel according to one embodiment.
FIG. 14 is a view illustrating a state in which a display apparatus according to one embodiment includes three display panels.
FIG. 15 is a view illustrating a state in which the display panels of the display apparatus of FIG. 14 are overlapped.

### [MODES OF THE INVENTION]

Embodiments described in the disclosure and configurations shown in the drawings are merely examples of the embodiments of the disclosure, and may be modified in various different ways at the time of filing of the present application to replace the embodiments and drawings of the disclosure.

In addition, the same reference numerals or signs shown in the drawings of the disclosure indicate elements or components performing substantially the same function.

Also, the terms used herein are used to describe the embodiments and are not intended to limit and / or restrict the disclosure. The singular forms "a," "an" and "the" are intended to include the plural forms as well, unless the context clearly indicates otherwise. In this disclosure, the terms "including", "having", and the like are used to specify features, numbers, steps, operations, elements, components, or combinations thereof, but do not preclude the presence or addition of one or more of the features, numbers, steps, operations, elements, components, or combinations thereof.

It will be understood that, although the terms first, second, third, etc., may be used herein to describe various elements, but elements are not limited by these terms. These terms are only used to distinguish one element from another element. For example, without departing from the scope of the disclosure, a first element may be termed as a second element, and a second element may be termed as a first element. The term of "and / or" includes a plurality of combinations of relevant items or any one item among a plurality of relevant items.

In the following detailed description, the terms of "up and down direction", "lower side", "front and rear direction", and the like may be defined by the drawings, but the shape and the location of the component is not limited by the term.

The disclosure will be described more fully hereinafter with reference to the accompanying drawings.

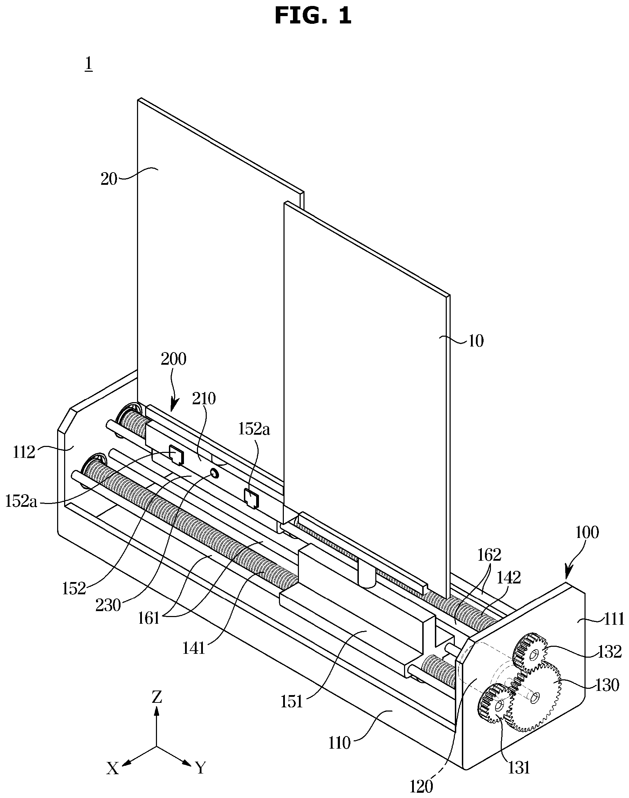

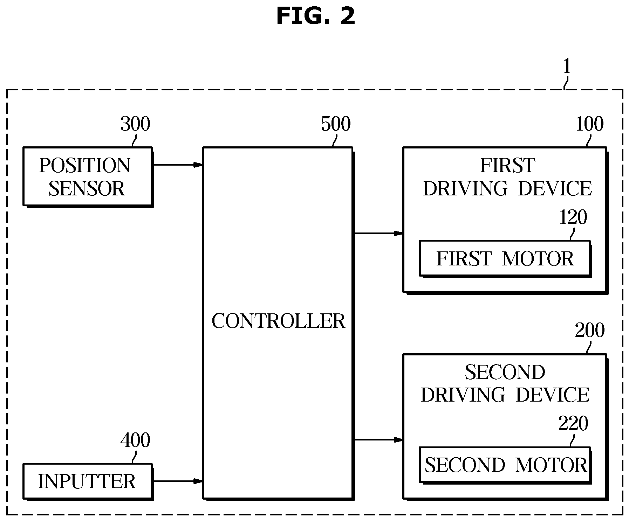

FIG. 1 is a view illustrating a display apparatus according to one embodiment. FIG. 2 is a control block diagram of the display apparatus 1 according to one embodiment.

Referring to FIG. 1, a display apparatus 1 according to one embodiment may be a self-luminous display apparatus in which a light-emitting element is arranged for each pixel to allow each pixel to emit light by itself. However, the present disclosure is not limited thereto, and the display apparatus 1 may be a non-self-luminous display apparatus that emits light using external light, such as a liquid crystal display (LCD). For convenience of description, the present disclosure will be described based on a self-luminous display apparatus that employs a light emitting diode (LED).

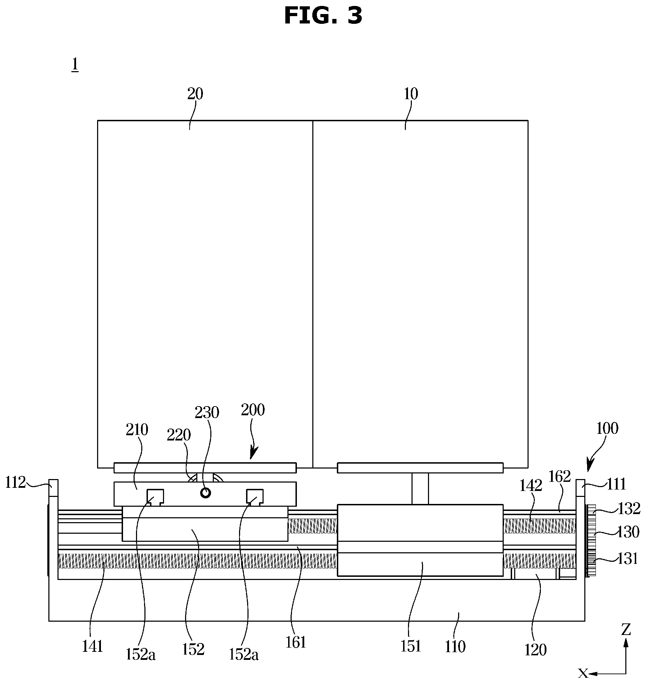

A display apparatus provided with micro-LEDs may be applied to various fields by utilizing their ultra-small pixel size and thin thickness. For example, as shown in FIG. 3, a large-screen may be implemented through display panels 10 and 20 onto which a plurality of LEDs is transferred, and the screen may be used as a signage, an electronic board, etc.

The display apparatus 1 may implemented with a thin thickness to allow light to pass therethrough, and have a simple structure to allow various design changes. In addition, the display apparatus 1 may be implemented as a flexible display apparatus.

The display apparatus 1 according to one embodiment may not need a backlight unit, a liquid crystal layer, or an encapsulating layer, but need an ultra-small micro-LED and a driving circuit and wiring for driving the micro-LED. Accordingly, it is more advantageous in securing an aperture ratio, which is an important factor in implementing a transparent display apparatus.

In embodiments described below, it is assumed that the display apparatus 1 is implemented as a transparent display apparatus.

Meanwhile, the three-dimensional coordinate system of the XYZ axes illustrated in FIG. 1 is based on the display apparatus 1, and a plane on which a screen of the display apparatus 1 is located is the YZ plane, and a direction in which an image is output or a light-emitting direction of a light-emitting element is the +X direction.

Generally, the display apparatus 1 is used in an upright state, and a user views an image from the front of the display apparatus 1. Accordingly, the +X direction in which the image is output may be the front, and the opposite direction may be the rear.

Because the illustrated coordinate system is based on the display apparatus 1, the same coordinate system may be applied whether the display apparatus 1 is lying down or standing up.

The display apparatus 1 may be composed of a plurality of pixels arranged twodimensionally. A single pixel may be composed of at least three sub-pixels that output light of different colors. For example, a single pixel may include a red sub-pixel configured to output red light, a green sub-pixel configured to output green light, and a blue sub-pixel configured to output blue light.

The sub-pixels may be arranged along the X-axis, along the Z-axis, or not arranged in a row. In addition, the sub-pixels may be implemented with different sizes. A single pixel only needs to include a plurality of sub-pixels to implement multiple colors, and there are no limitations on the size or arrangement of each sub-pixel.

In addition, a pixel does not necessarily have to be composed of a red sub-pixel configured to output red light, a green sub-pixel configured to output green light, and a blue sub-pixel configured to output blue light, and it is also possible to include a sub-pixel configured to output yellow light or white light. In other words, there is no limitation on the color or type of light output from each sub-pixel, or the number of sub-pixels. However, in the embodiments described below, for the specific description, a case in which a pixel is composed of a red sub-pixel, a green sub-pixel, and a blue sub-pixel will be described as an example.

The display apparatus 1 may include a first display panel 10 and a second display panel 20 that may be positioned to overlap at least a portion of the first display panel 10. For convenience of description, the following description will be based on the assumption that the first display panel 10 is positioned in front of the second display panel 20.

The first display panel 10 and the second display panel 20 may include a transmission area TA through which light may pass. The first display panel 10 and the second display panel 20 may include a light-emitting area that emits light. That is, the first display panel 10 and the second display panel 20 may be transparent display panels that display images while allowing objects located behind the display panels to be seen.

The first display panel 10 and the second display panel 20 may be provided with the same size. That is, the first display panel 10 and the second display panel 20 may completely overlap each other when positioned along the front and rear direction.

An image displayed by the second display panel 20 may pass through the first display panel 10. When a user is positioned in front of the display apparatus 1, the user can recognize the image displayed by the second display panel 20 together with an image displayed by the first display panel 10. In this way, the user can recognize the image in three dimensions by simultaneously recognizing the images displayed by the first display panel 10 and the second display panel 20. In other words, the display apparatus 1 may provide a three-dimensional effect to the image by overlapping the first display panel 10 and the second display panel 20.

It is illustrated that the first display panel 10 and the second display panel 20 are formed long in the up and down direction, but are not limited thereto and may have various sizes and shapes. The display panels 10 and 20 illustrated in the drawing are merely examples. Accordingly, when there is an overlapping portion although the first display panel 10 and the second display panel 20 have different shapes, a three-dimensional image may be implemented.

The display apparatus 1 may include a first driving device 100 configured to move at least one of a first display panel 10 and a second display panel 20. The first driving device 100 may move at least one of the first display panel 10 and the second display panel 20 to allow the first display panel 10 to overlap at least a portion of the second display panel 20. That is, by the first driving device 100, the first display panel 10 and the second display panel 20 may be moved to be completely overlapped or partially overlapped, or to have no overlapping area.

The first driving device 100 may move the first display panel 10 and the second display panel 20 in the left and right direction. The first driving device 100 may include a base 110 that extends in the left and right direction to allow the first display panel 10 and the second display panel 20 to move on the first driving device 100. The base 110 may include a left support 111 and a right support 112 which extend upward from left and right ends of the base 110, respectively. In the drawing, it is illustrated that a first motor 120, a motor gear 130, a first gear 131, a second gear 132, etc., which will be described later are coupled to the left support 111, but the present disclosure is not limited thereto and may be coupled to the right support 112.

The first driving device 100 may include the first motor 120 configured to generate rotational force to move the first display panel 10 or the second display panel 20, and the first motor 120 may include the motor gear 130 rotated by the first motor 120. The motor gear 130 may be rotated together with the first motor 120 as the first motor 120 generates rotational force.

The first driving device 100 may include the first gear 131 configured to be rotated by the rotation of the motor gear 130, and a first screw 141 connected to the first gear 131 and provided to extend from the left support 111 to the right support 112. The first gear 131 may be configured to mesh with the motor gear 130. However, the present disclosure is not limited thereto, and power may be transmitted via one or more other gears.

When the first gear 131 is configured to mesh with the motor gear 130, the first gear may rotate in a direction opposite to the rotational direction of the motor gear 130. When the first gear 131 rotates, the first screw 141 may also rotate. The first screw 141 may include a male thread formed along an outer circumferential surface thereof.

The first driving device 100 may include a first transfer unit 151 including a female thread formed to be coupled to the first screw 141. The first transfer unit 151 may include a mounting portion provided to allow the first display panel 10 to be mounted thereon, but any structure may be used as long as the first display panel 10 may be coupled thereto. The first transfer unit 151 may be formed to allow the first screw 141 to penetrate therethrough. The first transfer unit 151 may be moved while maintaining the coupling between the male thread formed along the outer circumferential surface of the first screw 141 and the female thread formed on the first transfer unit 151 as the first screw 141 rotates. An inside of the first transfer unit 151 may include a ball bearing (not shown) to facilitate movement with the first screw 141.

The first driving device 100 may include the second gear 132 configured to be rotated by the rotation of the motor gear 130, and a second screw 142 connected to the second gear 133 and provided to extend from the left support 111 to the right support 112. The second gear 132 may be configured to mesh with the motor gear 130. However, the present disclosure is not limited thereto, and power may be transmitted via one or more other gears. When the first gear 131 is configured to mesh with the motor gear 130, the first gear 131 may rotate in a direction opposite to the rotational direction of the motor gear 130. That is, when the motor gear 130 rotates, the first gear 131 and the second gear 132 may rotate in the opposite direction to the motor gear 130, but may also rotate in the same direction. When the second gear 132 rotates, the second screw 142 may also rotate, and the first screw 141 and the second screw 142 may rotate in the same direction.

The first driving device 100 may include a second transfer unit 152 configured to be movable along the second screw 142. The second transfer unit 152 may be formed to allow the second screw 142 to penetrate therethrough. The second transfer unit 152 may be moved while maintaining the coupling between a male thread formed along an outer circumferential surface of the second screw 142 and a female thread formed in the second transfer unit 152 as the second screw 142 rotates. The second transfer unit 152 may include a ball bearing (not shown) inside the second transfer unit 152 to facilitate movement with the second screw 142, similar to the first transfer unit 151. The ball bearing (not shown) may be provided at a location in which the first screw 141 or the second screw 142 is coupled to the left support 111 and the right support 112. This is to reduce friction and to facilitate rotation when the first screw 141 and the second screw 142 rotate.

In addition, the first screw 141 and the second screw 142 may be provided at different heights. In order to form a single continuous screen or display by being arranged side by side with the first display panel 10 positioned on the first screw 141, the second display panel 20 positioned on the second screw 142 needs to be moved forward by a second driving device 200.

At this time, the first screw 141 and the second screw 142 may be disposed at different heights to prevent the second driving device 200 from colliding with the first screw 141 or a first guide bar 161. In the drawing, it is illustrated that the second screw 142 is disposed above the first screw 141, but is not limited thereto. Alternatively, the first screw 141 may be disposed above the second screw 142.

However, when a moving block 210 of the second driving device 200 is disposed so as not to collide with the first screw 141 or the first guide bar 161 even when the first screw 141 and the second screw 142 are positioned at the same height, the first screw 141 and the second screw 142 may be allowed to be positioned at the same height. In this way, positions at which the first screw 141 and the second screw 142 are provided may have any structure as long as the positions do not interfere with the movement of the first display panel 10 and the second display panel 20.

As described above, the first screw 141 and the second screw 142 may include a male thread, and the first transfer unit 151 and the second transfer unit 152 may include a female thread. Conversely, the first screw 141 and the second screw 142 may include a female thread, and the first transfer unit 151 and the second transfer unit 152 may include a male thread.

Meanwhile, when the first screw 141 and the second screw 142 rotate in the same direction due to the rotation of the motor gear 130 and the rotation of the first gear 131 and the second gear 132 engaged with the motor gear 130, the first transfer unit 151 and the second transfer unit 152 may also move in the same direction. In this case, the first display panel 10 and the second display panel 20 may not be overlapped or arranged side by side, and thus the first transfer unit 151 and the second transfer unit 152 need to move in opposite directions.

Accordingly, the first screw 141 and the second screw 142 may include threads in opposite directions. For example, when the male thread of the first screw 141 is formed in a right-hand thread shape, the male thread of the second screw 142 may be formed in a lefthand thread shape. Conversely, when the male thread of the first screw 141 is formed in a lefthand thread shape, the male thread of the second screw 142 may be formed in a right-hand thread shape.

Meanwhile, when the display apparatus 1 is in the upright state, that is, when the base 110 is positioned in the up and down direction, the first display panel 10 and the second display panel 20 may move in the up and down direction. In this case, the method by which the first driving device 100 moves the first display panel 10 is the same as the method by which the first driving device 100 moves the second display panel 20.

The first driving device 100 may include the first guide bar 161 positioned parallel to the first screw 141 and a second guide bar 162 positioned parallel to the second screw 142. The first guide bar 161 and the second guide bar 162 may be coupled to the first transfer unit 151 and the second transfer unit 152, respectively. The first guide bar 161 and the second guide bar 162 may be positioned parallel to the first screw 141 and the second screw 142 so as not to interfere with the movement of the first transfer unit 151 and the second transfer unit 152.

At least one first guide bar 161 and at least one second guide bar 162 may be provided to prevent the rotation of the first transfer unit 151 and the second transfer unit 152. That is, when the first transfer unit 151 is supported only by the first screw 141, the first transfer unit 151 may rotate about the first screw 141 as a rotation axis, which may be structurally unstable. Therefore, in addition to the first screw 141, it is required to install at least one first guide bar 161 to prevent the rotation of the first transfer unit 151. Similarly, at least one second guide bar 162 may also be provided.

The display apparatus 1 may include the second driving device 200 configured to move at least one of the first display panel 10 or the second display panel 20 in the front and rear direction so as to adjust a distance between the first display panel 10 and the second display panel 20.

The second driving device 200 may include a second motor 220 configured to generate rotational force to move the first display panel 10 or the second display panel 20, and the moving block 210 to which the second transfer unit 152 and the first display panel 10 or the second display panel 20 are mounted and movably coupled. The second transfer unit 152 may include a moving guide 152a extending in the front and rear direction to allow the moving block 210 to be movably coupled in the front and rear direction. The moving guide 152a may extend to have a substantially rectangular cross-section, but is not limited thereto.

The second motor 220 may move the moving block 210 in the front and rear direction by the rotation of the second motor 220. As a motor screw 230 rotates, the moving block 210 may be moved while maintaining the coupling between a male thread formed along an outer circumferential surface of the motor screw 230 and a female thread formed on the moving block 210.

The second motor 220 may include the motor screw 230 connected to the second motor 220 so as to rotate by the rotational force of the second motor 220. The motor screw 230 may include the male thread on the outer circumferential surface thereof. The motor screw 230 may penetrate an inside of the moving block 210. The moving block 210 may include the female thread formed therein corresponding to the male thread of the motor screw 230. It should be understood that the motor screw 230 includes a female thread, and the moving block 210 includes a female thread.

**In** the drawing, it is illustrated that the first gear 131 and the second gear 132 are engaged with the motor gear 130 and rotated together by the rotation of the motor gear 130. However, the first gear 131 may include a separate motor, and the second gear 132 may also include a separate motor. Accordingly, the first gear 131 and the second gear 132 may rotate independently of each other. That is, when the first display panel 10 does not need to be moved, only the motor configured to drive the second gear 132 may be operated to move only the second display panel 20.

Referring to FIG. 2, the display apparatus 1 according to one embodiment may include an inputter 400 configured to receive an input from a user, a sensor (not shown) configured to detect a position of a user, a controller 500 configured to control the first driving device 100 or the second driving device 200, and the first driving device 100 and the second driving device 200 configured to move the first display panel 10 and the second display panel 20.

The display apparatus 1 may include the inputter 400 configured to receive a user input. The inputter 400 may receive various commands from a user to control the display apparatus 1, such as turning on/off the display apparatus 1, adjusting a volume, adjusting a channel, adjusting a screen, and changing various settings.

The inputter 400 may include a button or a touch pad disposed in an area of the display apparatus 1, and when the display panels 10 and 20 are implemented as a touch screen, the inputter 400 may include a touch pad disposed on the front surface of the display panels 10 and 20. In addition, the inputter 400 may also include a physical button, a switch, a knob, a remote controller, etc.

The display apparatus 1 may include a position sensor 300 configured to recognize a position of a nearby person. The display apparatus 1 may recognize a position of a person and detect a distance between the person and the display panels 10 and 20. The position sensor 300 may transmit information to the controller 500 to drive the second driving device 200 to adjust the distance between the first display panel 10 and the second display panel 20 according to the distance between the person and the display panels 10 and 20. For this, the position sensor 300 may be located in front of the display apparatus 1.

The display apparatus 1 may include the controller 500 configured to control the first driving device 100 or the second driving device 200 based on a user input received through the inputter 400. The controller 500 may control the first driving device 100 or the second driving device 200 to move the positions of the first display panel 10 and the second display panel 20.

Particularly, the controller 500 may control the start of operation of the first motor 120. When the left and right positions of the first display panel 10 and the second display panel 20 are appropriate, the controller 500 may stop the operation of the first motor 120. At this time, the controller 500 may control the start of operation of the second motor 220. By starting the operation of the second motor 220, the controller 500 may allow the second display panel 20 to be positioned on the same line as the first display panel 10, or may adjust the distance between the first display panel 10 and the second display panel 20.

However, the present disclosure is not limited thereto, and the controller 500 may simultaneously start the operations of the first motor 120 and the second motor 220 when the first display panel 10 and the second display panel 20 are disposed at positions which are determined that the collision does not occur.

The display apparatus 1 may be operated in a first mode that expands an image display region of the first display panel 10 and the second display panel 20, and a second mode that increases the resolution of an image displayed by the first display panel 10 and the second display panel 20. The controller 500 may control the first driving device 100 or the second driving device 200 to allow the display apparatus 1 to be operated in the first mode and the second mode. A specific description of the first mode that expands the image display region and the second mode that increases the resolution will be described later.

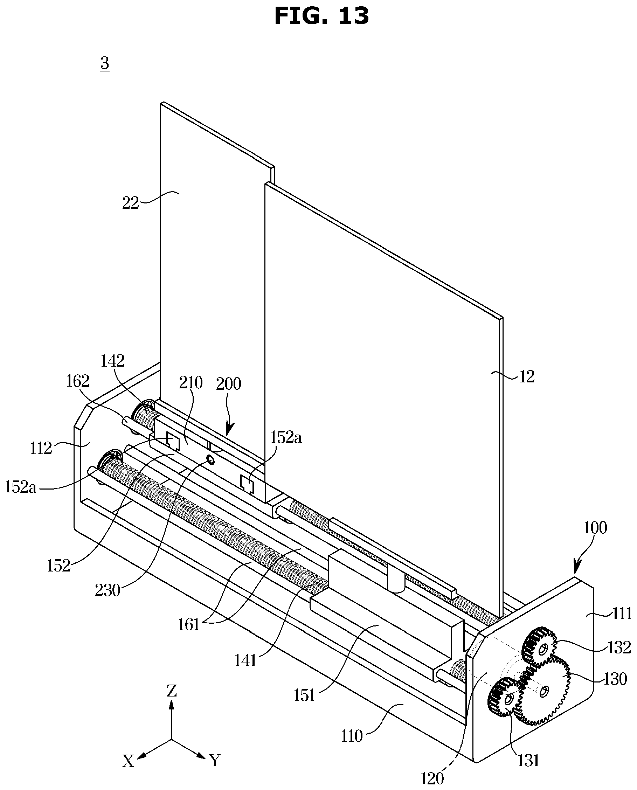

Meanwhile, in FIG. 1, the first display panel 10 and the second display panel 20 may be moved in the left and right direction by the first driving device 100, but only the second display panel 20 may be moved in the front and rear direction by the second driving device 200. However, in FIG. 13 described later, both the first display panel 10 and the second display panel 20 may be moved in the front and rear direction by the second driving device 200.

Hereinafter the expanded or overlapping state of the first display panel 10 and the second display panel 20 will be described.

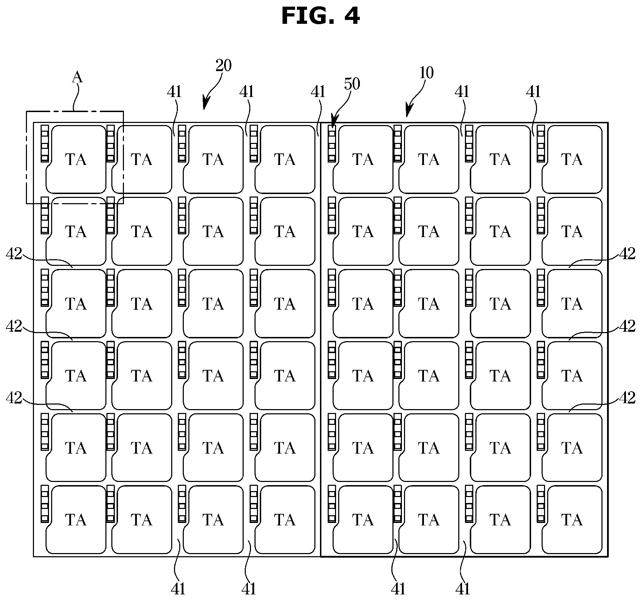

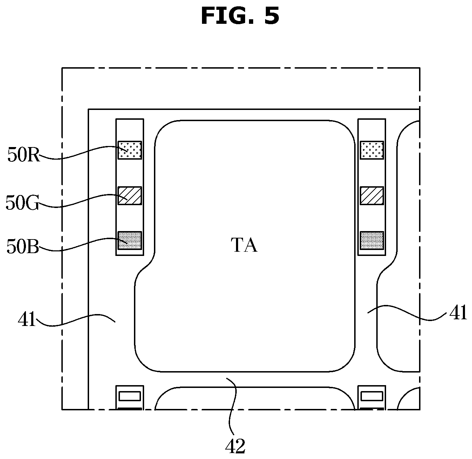

FIG. 3 is a view illustrating a state in which display panels of the display apparatus of FIG. 1 are expanded and arranged. FIG. 4 is a view illustrating a light-emitting area and a transmission area forming the display panel of FIG. 2. FIG. 5 is an enlarged view of a portion A, which is a portion of the light-emitting area and the transmission area of the display panel of FIG. 3.

Referring to FIGS. 3 to 5, in the display apparatus 1, the first display panel 10 and the second display panel 20 may be arranged side by side to expand the image display region.

A user can input a command, in which the display apparatus 1 is operated in the first mode to expand the image display region, to the inputter 400. The command received through the inputter 400 may be transmitted to the controller 500.

The controller 500 may operate the first driving device 100 and the second driving device 200 to allow the first display panel 10 and the second display panel 20 to be arranged side by side. The controller 500 may control the first motor 120 to start an operation so as to move the first display panel 10 and the second display panel 20 in the left and right direction. When the first display panel 10 and the second display panel 20 move to appropriate positions, the controller 500 may control the first motor 120 to stop the operation. Thereafter, the controller 500 may control the second motor 220 to start an operation so as to move the second display panel 20 to be arranged side by side with the first display panel 10. When the second display panel 20 is arranged side by side with the first display panel 10, that is, positioned in a straight line along the left and right direction, the controller 500 may control the second motor 220 to stop the operation.

However, when the first display panel 10 and the second display panel 20 are already in appropriate positions based on the left and right direction, that is, when the first display panel 10 and the second display panel 20 are arranged so as to be in contact with each other on the same line by moving in the front and rear direction, the controller 500 may control only the operation of the second motor 220. In this case, the controller 500 may start the operation of the second motor 220 and then stop the operation of the second motor 220 in response to the first display panel 10 and the second display panel 20 being arranged side by side to be located on the same line.

Accordingly, the first display panel 10 and the second display panel 20 may form a single continuous screen. The first display panel 10 and the second display panel 20 may be arranged side by side in the same line so as to form a single continuous screen. In other words, the first display panel 10 and the second display panel 20 may be arranged on the same line, that is, on the first screw 141 or the second screw 142, so as to be in contact with each other. The first display panel 10 and the second display panel 20 may form one continuous screen to display one image.

As the first display panel 10 and the second display panel 20 form a single extended display panel 10 and 20, a larger image display screen may be provided.

Hereinafter the structure inside the display panels 10 and 20 will be described in detail with reference to FIGS. 4 and 5.

Referring to FIG. 4, the first display panel 10 and the second display panel 20 may each include a light-emitting area 50 and a transmission area TA. The first display panel 10 and the second display panel 20 may each include a first wiring portion 41 and a second wiring portion 42 for supplying a control signal, power, etc. In order to secure the transmittance, it is required that the transmission area TA, through which light passes, be secured, and thus the first wiring portion 41 and the second wiring portion 42 may be arranged to intersect each other.

The first wiring portion 41 and the second wiring portion 42 may be formed of a material that allows light to pass through. However, because the transmission area TA includes a configuration formed of a material with a high transmittance, such as a transparent substrate, a transmittance of the first wiring portion 41 and the second wiring portion 42 may not be greater than that of the transmission area TA. Therefore, in order to secure the transmittance, it is advantageous for a region of the transmission area TA to be large.

For example, because the first display panel 10 and the second display panel 20 have a rectangular shape, the first wiring portion 41 and the second wiring portion 42 may be arranged in a two-dimensional grid shape. Each area formed by the intersection of the first wiring portion 41 and the second wiring portion 42 is a transparent area, and thus may become a transmission area TA through which light passes. An image displayed on the second display panel 20 may pass through the transmission area TA. All areas except the first wiring portion 41 and the second wiring portion 42 may become transmission areas TA, and thus a ratio of the transmission area TA may be maximized by adjusting a thickness and arrangement of the first wiring portion 41 and the second wiring portion 42.

As for the display panels 10 and 20 according to one embodiment, the first wiring portion 41 may be arranged in the up and down direction and the second wiring portion 42 may be connected in the left and right direction. The first wiring portion 41 and the second wiring portion 42 may be arranged in a grid shape and thus the first wiring portion 41 and the second wiring portion 42 may be provided in plurality. FIG. 3 illustrates that the first display panel 10 and the second display panel 20 includes five first wiring portions 41 and seven second wiring portions 42, respectively.

The first display panel 10 and the second display panel 20 may be provided in shapes other than rectangles. For example, the first display panel 10 and the second display panel 20 may be provided in various shapes such as circles, ovals, and polygons. In this case, a wiring structure of the first display panel 10 and the second display panel 20 may not necessarily be a two-dimensional grid shape, and may be provided in various shapes such as a mesh structure and a radial structure.

The light-emitting area 50 may be arranged on the first wiring portion 41. The light-emitting area 50 may be arranged while maintaining a predetermined interval. In the drawing, it is illustrated that the light-emitting area 50 is arranged lengthwise along a longitudinal direction of the first wiring portion 41, but is not limited thereto. Alternatively, each of light-emitting elements 50R, 50G and 50B may be arranged in various shapes such as a triangle.

Referring to FIG. 5, the light-emitting elements 50R, 50G and 50B may be provided in the light emitting area 50. One light emitting element may include a red light-emitting element 50R, a green-light emitting element 50G, and a blue-light emitting element 50B. The red light-emitting element 50R, the green light-emitting element 50G, and the blue light-emitting element 50B may be mounted on the light-emitting area 50. The red light-emitting element 50R, the green light-emitting element 50G, and the blue light-emitting element 50B may form a single pixel.

The light-emitting area 50 may be provided to allow the red light-emitting element 50R, the green light-emitting element 50G, and the blue light-emitting element 50B to be mounted thereon, respectively. That is, a light-emitting area 50 in which the red light-emitting element 50R is mounted, a light-emitting area 50 in which the green light-emitting element 50G is mounted, and a light-emitting area 50 in which the blue light-emitting element 50B is mounted may be individually provided.

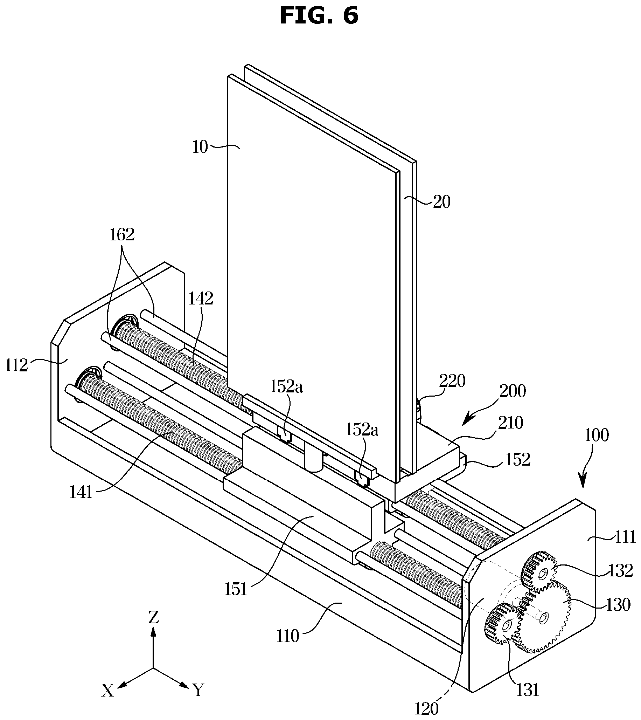

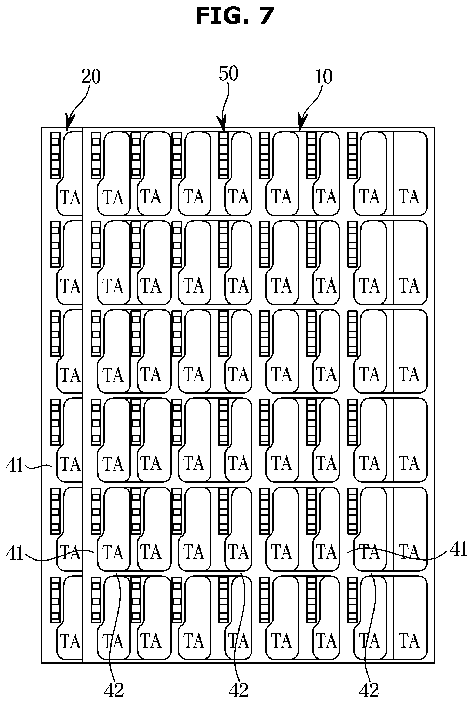

FIG. 6 is a view illustrating a state in which the display panels of the display apparatus of FIG. 1 are overlapped and arranged. FIG. 7 is a view illustrating the light-emitting area and the transmission area forming the display panel of FIG. 6.

Referring to FIGS. 6 and 7, in the display apparatus 1, the first display panel 10 and the second display panel 20 may overlap each other to provide a three-dimensional effect to an image displayed thereon. The image displayed on the second display panel 20 located further rearward may pass through the transmission area TA of the first display panel 10 and be recognized by a user. The user can recognize the perspective of the image displayed by the first display panel 10 and the image displayed by the second display panel 20 and thus the user can feel the three-dimensional effect of the image.

In addition, the light-emitting area 50 located in the first display panel 10 and the light-emitting area 50 located in the second display panel 20 may be positioned alternately. Particularly, the light-emitting area 50 of the first display panel 10 may be positioned to correspond to the transmission area TA of the second display panel 20. Conversely, the light-emitting area 50 of the second display panel 20 may be positioned to correspond to the transmission area TA of the first display panel 10. Because internal structures of the first display panel 10 and the second display panel 20 have the same shape, the light-emitting areas 50 may be uniformly distributed over the entire areas of the first display panel 10 and the second display panel 20.

The resolution of the display is calculated by the number of pixels displayed on the screen, and thus the higher the number of pixels displayed in the same region, that is, the greater the number of light-emitting areas 50, the higher the resolution. When the first display panel 10 and the second display panel 20 completely overlap, a user can recognize only the first display panel 10, which is located further in front, as a screen display area. However, the light-emitting area 50 of the second display panel 20 may be seen through the screen display area of the first display panel 10, and thus a larger number of pixels may be displayed.

In other words, the number of light-emitting areas 50 displayed on a screen having the same size as the first display panel 10 may be the total of the number of light-emitting areas 50 of the first display panel 10 and the number of light-emitting areas 50 of the second display panel 20. Accordingly, the resolution of the screen displayed by the display panels 10 and 20 may be approximately doubled.

In order to increase the resolution, the positions of the first display panel 10 and the second display panel 20 may be intentionally arranged to cross each other. This is because when the first display panel 10 and the second display panel 20 completely overlap, the light-emitting area 50 of the second display panel 20 may not be positioned to correspond to the transmission area TA of the first display panel 10 because the first display panel 10 and the second display panel 20 are formed with the same structure.

Meanwhile, when the first display panel 10 and the second display panel 20 completely overlap, the internal structure thereof may be intentionally moved to allow the light-emitting area 50 of the second display panel 20 to be positioned to correspond to the transmission area TA of the first display panel 10.

A user can input a command, in which the display apparatus 1 is operated in the second mode to increase the resolution of an image displayed thereon, to the inputter 400. The command received through the inputter 400 may be transmitted to the controller 500. The controller 500 may operate the first driving device 100 and the second driving device 200 to completely overlap the first display panel 10 and the second display panel 20 or intentionally position the first display panel 10 and the second display panel 20 to be cross.

The controller 500 may control the first motor 120 to be operated. By the operation of the first motor 120, the first display panel 10 and the second display panel 20 may be moved in the left and right direction. When the light-emitting area 50 of the second display panel 20 is moved to be positioned in the transmission area TA of the first display panel 10, the controller 500 may control the first motor 120 to stop the operation thereof.

A user can input a command, in which the display apparatus 1 is operated in a third mode to prevent a decrease in transmittance while increasing the resolution of an image displayed thereon, to the inputter 400. The command received through the inputter 400 may be transmitted to the controller 500.

The controller 500 may control the display apparatus 1 to be operated in the third mode to prevent a decrease in transmittance while increasing the resolution of the displayed image. That is, the controller 500 may control the display apparatus 1 to be operated in the third mode to increase the transmittance in the second mode that increases the resolution of the displayed image. Particularly, the controller 500 may control the first motor 120 to be operated, and when the light-emitting area 50 of the second display panel 20 overlaps at least a portion of the first wiring portion 41 of the first display panel 10 due to the operation of the first motor 120, the controller 500 may control the first motor 120 to stop the operation thereof.

The first display panel 10 and the second display panel 20 may be arranged in the front and rear direction to display images respectively, thereby providing a three-dimensional image. In addition, the resolution may be increased by allowing the light-emitting area 50 of the second display panel 20 to be positioned in the transmission area TA of the first display panel 10.

The display apparatus 1 may adjust the distance between the first display panel 10 and the second display panel 20 in a state in which the first display panel 10 and the second display panel 20 are overlapped. When the distance between the first display panel 10 and the second display panel 20 is reduced, the three-dimensional effect may decrease. When the distance thereof is increased, the three-dimensional effect may increase, but a cardboard effect may occur, thereby causing an unnatural feeling. Therefore, the distance between the first display panel 10 and the second display panel 20 needs to be appropriately maintained.

The position sensor 300 may detect a user's position. The position sensor 300 may detect the distance from the display apparatus 1 to the user's position and transmit the information to the controller 500.

The controller 500 may control the operation of the second driving device 200 to adjust the distance between the first display panel 10 and the second display panel 20. Particularly, when the controller 500 determines that the distance from the display apparatus 1 to the user's position is close, the controller 500 may control the second motor 220 to be rotated so as to move the second display panel 20 forward. When the distance is adjusted to an appropriate level, the controller 500 may control the second motor 220 to stop the operation thereof.

Meanwhile, when the controller 500 determines that the distance from the display apparatus 1 to the user's position is far, the controller 500 may control the second motor 220 to be rotated in the opposite direction so as to move the second display panel 20 backward. Similarly, when the distance is adjusted to an appropriate level, the controller 500 may control the second motor 220 to stop the operation thereof.

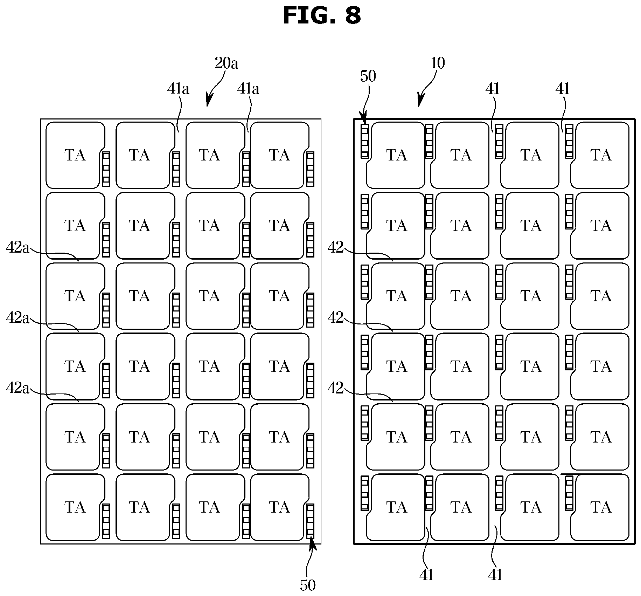

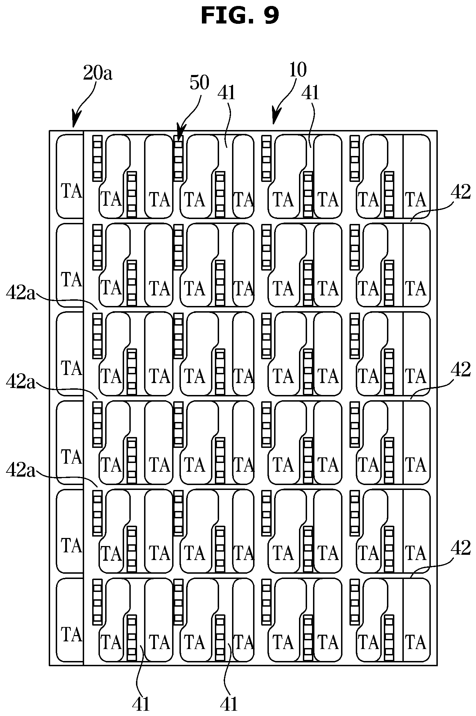

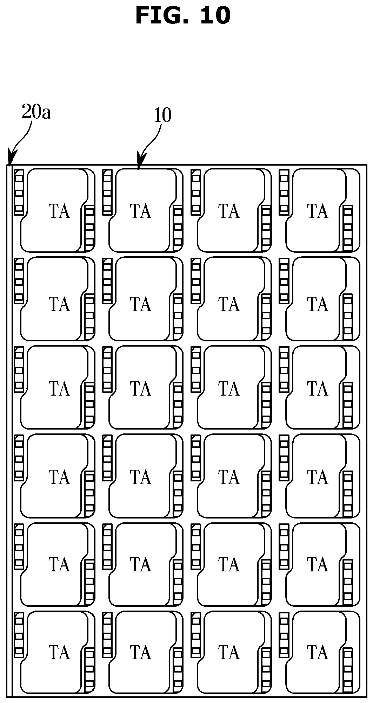

FIG. 8 is a view illustrating a structure of a light-emitting area and a transmission area forming a display panel of a display apparatus according to one embodiment. FIG. 9 is a view illustrating a state in which the display panels of the display apparatus of FIG. 8 are overlapped and arranged. FIG. 10 is a view illustrating a state in which the display panels of the display apparatus of FIG. 8 are arranged in a manner different from that of FIG. 9.

Referring to FIGS. 8 to 10, internal structures of a first display panel 10 and a second display panel 20 may be provided differently from each other. For example, as illustrated in FIG. 8, a light-emitting area 50 of a second display panel 20a may be provided at a different height from a light-emitting area 50 of the first display panel 10. In other words, the light-emitting area 50 of the second display panel 20a may be located in a first wiring portion 41, but may be located close to a second wiring portion 42 passing under the transmission area TA. In other words, a wiring structure of the second display panel 20a may be the same as that of rotating a wiring structure of the first display panel 10 by 180 degrees clockwise. It is sufficient for the wiring structures of the first display panel 10 and the second display panel 20a to be formed opposite each other, and it is sufficient for the structure of the first display panel 10 to be changed.

As the wiring structures of the first display panel 10 and the second display panel 20a are provided differently from each other, it is possible to obtain the effect of increasing the transmittance when the first display panel 10 and the second display panel 20 are overlapped.

Particularly, referring to FIG. 7, as the light-emitting area 50 of the second display panel 20 is positioned to correspond to the transmission area TA of the first display panel 10, the transmission area TA of the first display panel 10 may be narrower than before overlapping. Accordingly, the wiring structure of the second display panel 20a may be provided as illustrated in FIG. 8.

The first display panel 10 and the second display panel 20a including the wiring structure of FIG. 8 may provide an image with uniform and increased resolution by positioning the light-emitting area 50 of the second display panel 20a to correspond to the transmission area TA of the first display panel 10.

Further, referring to FIG. 10, the light-emitting area 50 of the second display panel 20 may be positioned to overlap at least a portion of the first wiring portion 41 of the first display panel 10. In this case, a region of the transmission area TA of the first display panel 10 covered by the light-emitting area 50 of the second display panel 20a and the first wiring portion 41 may be reduced. The first wiring portion 41 and the second wiring portion 42 may also be formed of a material that allows light to be transmitted. However, even when light is transmitted, a transmittance of the first wiring portion 41 and the second wiring portion 42 may not be greater than that of the transmission area TA, and thus it may be more advantageous to secure the region of the transmission area TA.

Accordingly, by overlapping the first display panel 10 and the second display panel 20a, the resolution of the display may be increased while preventing a decrease in the transmittance. Accordingly, the function as a transparent display may be maintained while providing the more increased resolution.

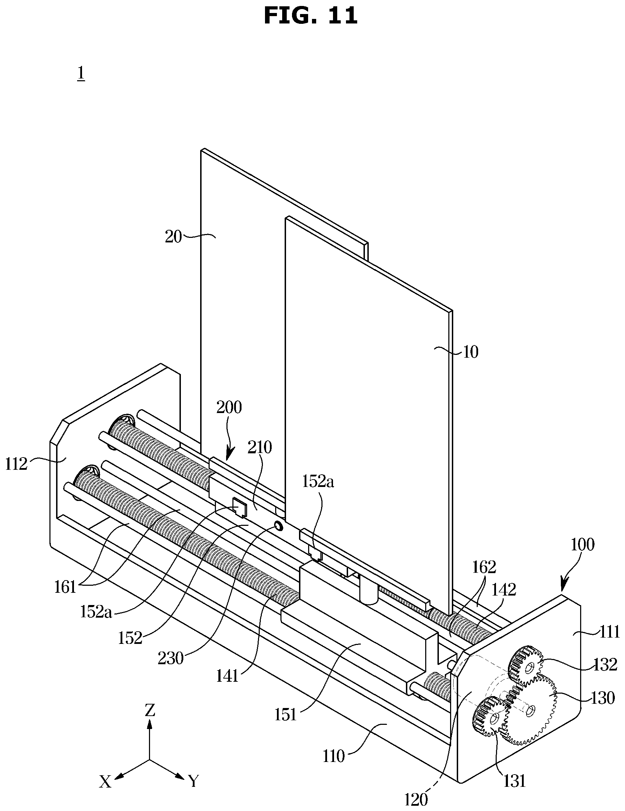

FIG. 11 is a view illustrating a state in which a portion of the display panels of the display apparatus of FIG. 1 are overlapped and arranged.

Referring to FIG. 11, the second display panel 20 may be positioned to overlap at least a portion of the first display panel 10. A portion of an area where the second display panel 20 overlaps the first display panel 10 may display a three-dimensional image. An area of the second display panel 20 that do not overlap the first display panel 10 and an area of the first display panel 10 that do not overlap the second display panel 20 may display general images.

For example, when an image to be displayed is a person or object requiring a three-dimensional effect and a text requiring readability, the display apparatus 1 may overlap only a portion of the first display panel 10 and a portion of the second display panel 20 to display the image of the person or object in the overlapping area and display the text in the non-overlapping area. As another example, when an image to be displayed is a moving image expressing a moving object, etc., the display apparatus 1 may move the area displaying the three-dimensional image while moving the overlapping area between the first display panel 10 and the second display panel 20. As described above, the method of moving the overlapping area between the first display panel 10 and the second display panel 20 may utilize the method of operating the first driving device 100 or the second driving device 200. However, even in the case of the text in the above example, when a three-dimensional effect is required, the text may be displayed in the overlapping area.

Hereinafter detailed descriptions of the same configurations as those described in FIGS. 1 to 11 may be omitted. In addition, the same reference numerals may be assigned to the same configurations, and descriptions will be given to configurations that are different from those of the above embodiments.

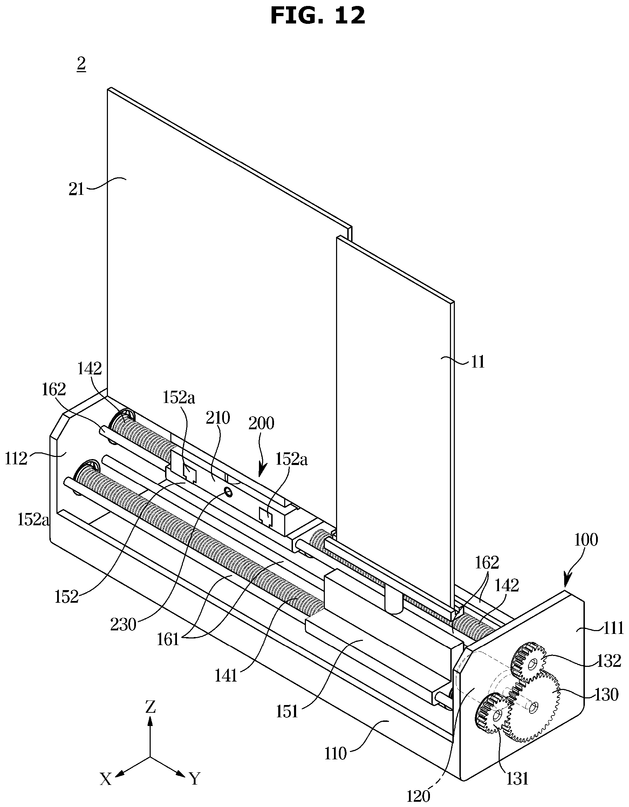

FIG. 12 is a view illustrating a state in which sizes of display panels of a display apparatus are different from each other. FIG. 13 is a view illustrating a state in which sizes of display panels of a display apparatus are different from each other.

Referring to FIGS. 12 and 13, first display panels 11 and 12 and second display panels 21 and 22 of display apparatuses 2 and 3 may be provided with different sizes. In addition, the first display panels 11 and 12 and the second display panels 21 and 22 may be provided with different shapes. For example, the second display panels 21 and 22 may be provided with a large rectangular shape, and the first display panels 11 and 12 may be provided with different shapes such as a circle, an ellipse, a polygon, etc. Accordingly, as the first display panels 11 and 12 move, an area, on which a three-dimensional image is displayed, i.e., an overlapping area, may move while having various shapes.

As illustrated in FIG. 12, a first display panel 11 of a display apparatus 2 may be formed to have a smaller size than a second display panel 21. It is illustrated that the first display panel 11 has a narrower width in the left and right direction than the second display panel 21 but has the same height as the second display panel 21. Alternatively, the first display panel 11 may have the same width in the left and right direction as the second display panel 21, but may have a shorter height than the second display panel 21.

The second display panel 21 may display a large screen, and thus the second display panel 21 may display a background screen. The first display panel 11 may display a small screen, and thus the first display panel 11 may display an image that is intended to be displayed using the second display panel 21 as a background.

As illustrated in FIG. 13, a first display panel 12 of a display apparatus 3 may be formed to have a larger size than a second display panel 22. It is illustrated that the first display panel 12 has a narrower width in the left and right direction than the second display panel 22 but has the same height as the second display panel 22. Alternatively, the first display panel 12 may have the same width in the left and right direction as the second display panel 22, but may have a shorter height than the second display panel 22.

In this case, the first display panel 12 may be used as a background, and an image to be displayed beyond the background of the first display panel 12 may be displayed on the second display panel 22.

The above description is only an example, and the first display panels 11 and 12 or the second display panels 21 and 22 may move relative to each other to provide various three-dimensional images.

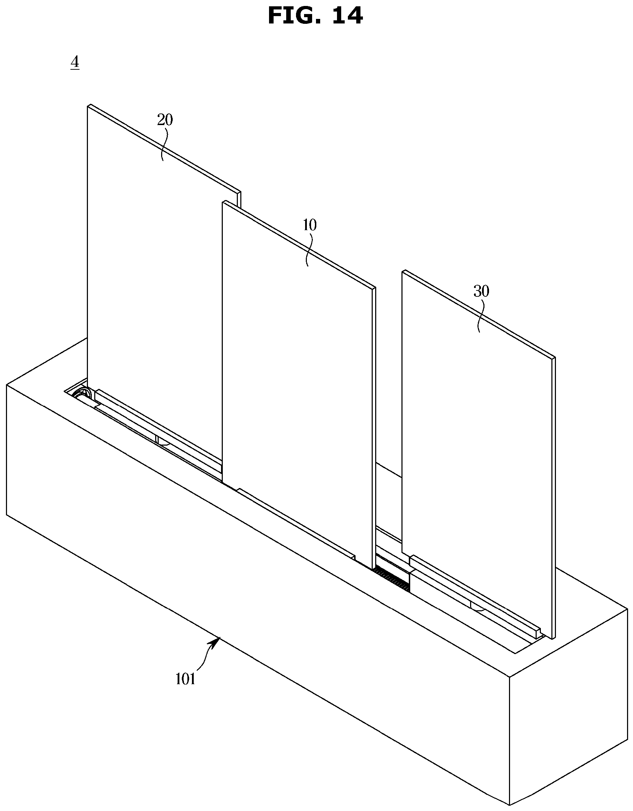

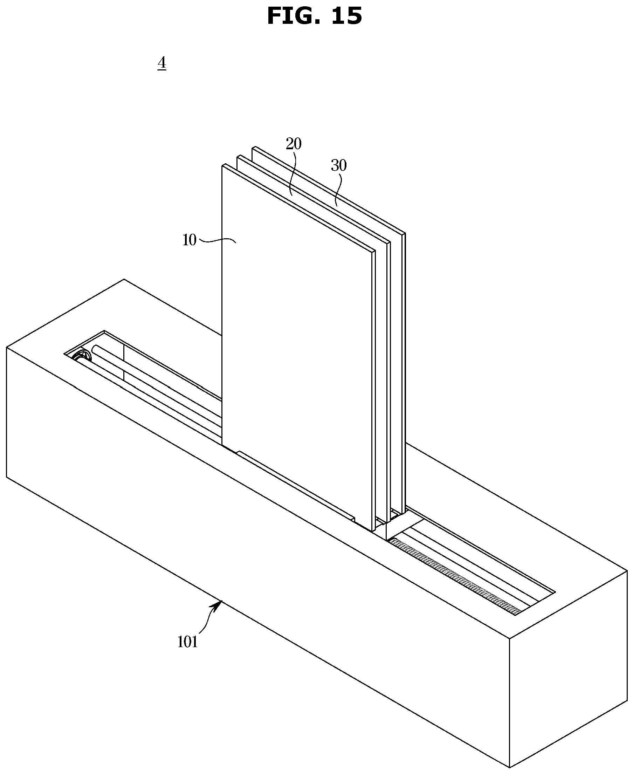

FIG. 14 is a view illustrating a state in which a display apparatus according to one embodiment includes three display panels. FIG. 15 is a view illustrating a state in which the display panels of the display apparatus of FIG. 14 are overlapped.

Referring to FIGS. 14 and 15, a display apparatus 4 may include a third display panel 30 positioned to overlap at least a portion of a first display panel 10 or a second display panel 20. It is illustrated that the third display panel 30 has the same size and shape as the first display panel 10 and the second display panel 20, but is not limited thereto. Alternatively, the third display panel 30 may have a different size or shape. In addition, the third display panel 30 may include a first wiring portion 41 and a second wiring portion 42 in the same manner as the first display panel 10 and the second display panel 20, and may include a light-emitting area 50 and a transmission area TA.

The display apparatus 4 may include a first driving device 101 or a second driving device (not shown) to move the third display panel 30. The first driving device 101 may include a third screw (not shown), a third transfer unit (not shown), etc. A driving method of the first driving device 101 or the second driving device (not shown) may be the same as the driving method of the first driving device 100 or the second driving device 200 described above. In addition, the third display panel 30 may be fixedly positioned without moving, and the first display panel 10 or the second display panel 20 may be positioned to be moved and overlapped by the first driving device 101 and the second driving device (not shown), respectively.

The first display panel 10, the second display panel 20, and the third display panel 30 may be arranged side by side on the same line to form one extended display panel 10, 20, and 30. That is, the first display panel 10, the second display panel 20, and the third display panel 30 may be arranged side by side to form a single continuous screen. **In** addition, the first display panel 10 and the second display panel 20 may be overlapped to display a three-dimensional image, and may be arranged to increase the resolution.

Among the first to third display panels 10, 20, and 30, two display panels may form a single continuous screen and the remaining one display panel may be arranged at the front or the rear of the continuous screen. Accordingly, the first to third display panels 10, 20, and 30 may be configured to be the same as the display apparatus 2 or 3 including the first display panel 10 and the second display panel 20 having the different sizes. For example, the first display panel 10 and the second display panel 20 may be arranged side by side at the front to form one continuous screen, and the third display panel 30 may be arranged at the rear. Conversely, the second display panel 20 and the third display panel 30 may be arranged side by side at the rear to form one continuous screen, and the first display panel 10 may be arranged at the front. Accordingly, it is possible to have the effect of having the different sizes with the display panels 10, 20 and 30 having the same size and shape.

The effect and structure according to the arrangement of the first display panel 10 and the second display panel 20 described above may be equally applied even when the third display panel 30 is provided together, and the moving method may be equally applied.

For example, the wiring structure of the third display panel 30 may be a form in which the wiring structure of the second display panel 20 shown in FIG. 8 is inverted left and right. In this case, as illustrated in FIG. 16, when the display panels 10, 20, and 30 overlap, the number of pixels displayed within the same region may increase and thus a higher resolution screen may be displayed. In this way, even when the display panels 10, 20, and 30 are composed of three or more display panels, the effect of increasing the resolution may be obtained while securing the transmittance.

While the present disclosure has been particularly described with reference to exemplary embodiments, it should be understood by those of skilled in the art that various changes in form and details may be made without departing from the spirit and scope of the present disclosure.

## Claims

1. A display apparatus comprising:
a first display panel, and a second display panel capable of being positioned to at least partially overlap the first display panel, each of the first display panel and the second display panel comprising a light-emitting area and a transmission area through which light is transmitted;
a first driving device configured to move at least one of the first display panel or the second display panel to allow the first display panel to overlap at least a portion of the second display panel, and comprising a first motor; and
a second driving device configured to move at least one of the first display panel or the second display panel in a front and rear direction so as to adjust a distance between the first display panel and the second display panel, the second driving device comprising a second motor.

2. The display apparatus of claim 1, wherein the light-emitting area of the second display panel is positioned to correspond to the transmission area of the first display panel.

3. The display apparatus of claim 1, wherein each of the first display panel and the second display panel comprises: a first wiring portion in which the light-emitting area is positioned, and a second wiring portion that intersects the first wiring portion and forms the transmission area together with the first wiring portion, and
wherein the light-emitting area of the second display panel is positioned to overlap with at least a portion of the first wiring portion of the first display panel.

4. The display apparatus of claim 3, wherein the first wiring portion and the second wiring portion intersect each other vertically.

5. The display apparatus of claim 1, wherein the first display panel and the second display panel are capable of being arranged side by side to form a single continuous screen.

6. The display apparatus of claim 1, wherein the first display panel and the second display panel are capable of being arranged along the front and rear direction to allow all areas of the first display panel and the second display panel to overlap each other.

7. The display apparatus of claim 6, wherein in response to the overlap of the first display panel and the second display panel, the light-emitting area of the second display panel is capable of being positioned to correspond to the transmission area of the first display panel.

8. The display apparatus of claim 6, wherein each of the first display panel and the second display panel comprises: a first wiring portion in which the light-emitting area is positioned, and a second wiring portion that intersects the first wiring portion and forms the transmission area together with the first wiring portion, and
wherein in response to the overlap of the first display panel and the second display panel, the light-emitting area of the second display panel is capable of being positioned to overlap at least a portion of the first wiring portion of the first display panel.

9. The display apparatus of claim 1, wherein the first display panel and the second display panel have different sizes.

10. The display apparatus of claim 9, wherein the second display panel is provided to be smaller than the first display panel.

11. The display apparatus of claim 1, further comprising:
a third display panel positioned to overlap at least a portion of the first display panel or the second display panel,
wherein the third display panel is capable of being arranged side by side with the first display panel and the second display panel to form a single continuous screen.

12. The display apparatus of claim 1, wherein the first driving device further comprises:
a motor gear configured to be rotated by the first motor;
a first gear configured to be rotated by a rotation of the motor gear;
a first screw configured to be rotated together with the first gear; and
a first transfer unit configured to be movable along the first screw.

13. The display apparatus of claim 12, wherein the first driving device further comprises:
a second gear configured to be rotated by a rotation of the motor gear;
a second screw configured to be rotated together with the second gear and positioned parallel to the first screw; and
a second transfer unit configured to be movable along the second screw, and
wherein the second screw has a thread in a different direction from the first screw.

14. The display apparatus of claim 13, wherein the second driving device further comprises: a moving block mounted on the second display panel and movably coupled to the second transfer unit, and
wherein the moving block is moved in the front and rear direction by the rotation of the second motor.

15. The display apparatus of claim 1, further comprising:
a controller configured to control the first driving device or the second driving device based on a user input,
wherein the controller controls the first driving device or the second driving device to allow the display apparatus to be operated in a first mode for expanding an image display region and a second mode for increasing a resolution.
